# EUROPEAN PATENT APPLICATION

(11) **EP 3 174 096 A1**
(43) Date of publication of application: **31.05.2017**
(21) Application number: 15196771.8
(22) Date of filing: 27.11.2015
(51) Int. Cl.: H01L 27/08, H01L 49/02, H01L 29/8605

(54) **DIFFUSED RESISTOR**

(71) Applicant: NXP B.V., 5656 AG Eindhoven (NL)
(72) Inventor: VAN VELDHOVEN, Robert, Redhill, Surrey RH1 1SH (GB); CANDAN, Ibrahim, Redhill, Surrey RH1 1SH (GB); VAN GELOVEN, Johannes, Redhill, Surrey RH1 1SH (GB)
(74) Representative: Terblanche, Candice Jane

(57) **Abstract**

A diffused resistor and method for forming a diffused resistor are provided. The diffused resistor comprises a substrate having a first conductivity type; a first well within the substrate having a second conductivity type; and a second well within the first well having the first conductivity type. The resistor further comprises a first and second contact for coupling the resistor to further circuitry. The first and second contacts are each coupled to both the first well and the second well.

## Description

### Field

The present disclosure relates to resistors forming part of a semiconductor device and in particular to an implementation of a diffused resistor in a semiconductor device.

### Background

Metal Oxide Semiconductor Field Effect Transistors (MOSFETs) may be implemented using a polysilicon material to form a gate contact for the MOSFET. Polysilicon may also be used to form resistors within the semiconductor device. These resistors may be advantageous in several applications because they have a high level of linearity.

A trend in semiconductor manufacturing is to use technologies that allow smaller and smaller feature size. In these devices, the MOSFET gates may be implemented using a metal with a high dielectric constant (high-k material) in place of the polysilicon. In these cases, the use of polysilicon may no longer be standard and providing an additional mask for a polysilicon layer to form resistors may be expensive.

An alternative implementation of the resistors may be of interest.

### Summary

According to a first aspect, there is provided a diffused resistor comprising: a substrate having a first conductivity type; a first well within the substrate having a second conductivity type; a second well within the first well having the first conductivity type; a first and second contact for coupling the resistor to further circuitry; wherein the first and second contacts are each coupled to both the first well and the second well.

The second well may be configured to form a resistor body. The first contact may be coupled to both the first well and the second well on a first side of the resistor and the second contact is coupled to both the first well and the second well on a second side. The second conductivity type may be opposite the first conductivity type. The first conductivity type may be one of an n-type or a p-type and the second conductivity type is the other one of the n-type or the p-type.

The first contact may be configured to provide a low voltage terminal of the diffused resistor. The second contact may be configured to provide a high voltage terminal of the diffused resistor. The diffused resistor may further comprise: one or more further contacts provided between the first and second contacts. The contacts may be provided on a top surface of the second well. The diffused resistor may be a resistor divider.

According to a second aspect, there is provided a semiconductor device comprising a diffused resistor according to the first aspect.

According to a third aspect, there is provided a method comprising: providing a substrate having a first conductivity type; forming a first well within the substrate having a second conductivity type; forming a second well within the first well having the first conductivity type; forming a first and second contact for coupling the resistor body to further circuitry; wherein forming the first and second contact further comprises: forming the first contact with connections to the first well and the second well; and forming the second contact with connections to the first well and the second well.

Forming the second well may form a resistor body. The first contact may be formed on a first side of the resistor body and the second contact may be formed on a second side of the resistor body. The method may further comprise: forming one or more further contacts between the first and second contacts. The contacts may be formed on a top surface of the second well.

According to a fourth aspect, there is provided a voltage to current converter comprising: a voltage input; a voltage output; an amplifier comprising: an amplifier output coupled to the voltage output; an impedance coupled between the voltage output and an inverting input of the amplifier; and a non-inverting input coupled to ground; wherein the voltage to current converter further comprises: the resistor of claim 1 wherein the first contact is coupled to the voltage input and the second contact is coupled to the inverting input of the amplifier.

### Figures

Embodiments will be described, by way of example only, with reference to the drawings, in which:
Figure 1 is a schematic diagram showing a semiconductor device;
Figure 2 is a schematic diagram showing an example of a diffused resistor in accordance with a first embodiment;
Figure 3 is a flow diagram depicting the method steps of manufacturing a semiconductor device of the first embodiment;
Figures 4a and 4b a show first and second example circuit diagrams of a diffused resistor in accordance with the first and second embodiments;
Figure 5a is a circuit diagram of an example application in which embodiments may be implemented; and
Figure 5b is a schematic diagram showing an embodiment implemented in the application of figure 5a.

### Description:

An alternative to a polysilicon resistor may be a diffused resistor. Diffused resistors may be manufactured, for example, during the base diffusion of an integrated transistor and thus may be compatible with technologies where a high-k metal is used for a transistor gate contact. Diffused resistors are not considered to be an alternative to implementing a voltage divider due to the characteristics of the diffused resistors. For example, diffused resistors are not considered to be linear.

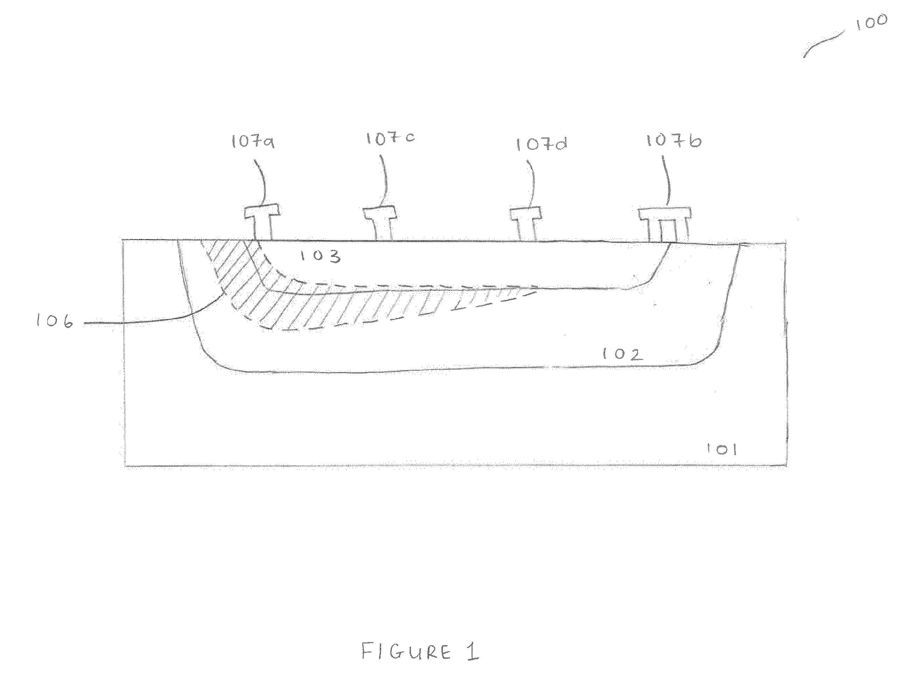

Figure 1 shows an example of a semiconductor device 100 comprising a diffused resistor. The semiconductor device 100 of figure 1 comprises a substrate 101, a first well 102 within the substrate and a second well 103 within the first well 102. The first well 102 may have a conductivity type that is opposite to that of the substrate 101 and the second well 103.

Resistor contacts may be provided on the top surface of the semiconductor device 100. In this example, the device 100 comprises a first contact 107a provided on the second well 103 side of a boundary between the first well 102 and the second well 103. The device 100 may further comprise a second contact 107b provided on both sides of the boundary between the first well 102 and the second well 103. A third and fourth resistor contact 107c and 107d may be provided on the top surface of the third well 103, between the first and second resistor contacts 107a and 107b.

In this example, the diffused resistor is provided as a resistor divider having four contacts, however it will be appreciated that diffused resistors may comprise two or more contacts.

As discussed, the first contact 107a is coupled to the surface of the second well 103 and the second contact 107b is coupled both to the surface of the second well 103 and the surface of the first well 102. When in use, the first contact 107a may be coupled to provide the low voltage side of the resistor (V_{L}) and the second contact 107b may be coupled to provide the high voltage side (V_{H}) of the resistor. In one example, V_{L} may be coupled to ground however it will be appreciated that any suitable coupling may be used as long as V_{H} is at a voltage greater than the voltage at V_{L}.

In this case, the first contact 107a may be at a first voltage V_{L}, the third contact 107c may be at a second voltage, the fourth contact 107d at a third voltage and the second contact 107b at a fourth voltage V_{H}. In theory, the difference between the first and second voltage, the second and third voltage, and the third and fourth voltage is equal for contacts placed equidistantly along the resistor body 103. However, this may not be true for a non-linear resistor.

The resistor provided by the semiconductor device 100 may be non-linear and, in particular, may be voltage dependent. The relationship between the second well 103 and the first well 102 may be modelled as a first diode and the relationship between the first well 102 and the substrate 101 may be modelled as a second diode.

The second contact 107b is coupled to both the second well 103 and the first well 102 as well as coupled to the V_{H} of the resistor and so the voltage across the boundary between the first well 102 and the second well 103 is 0V. Thus the voltage across the first diode is 0V in the region of the second contact 107b. The first contact is coupled to a low voltage, so the voltage difference between the second well 103 and the first well 102 in the vicinity of the first contact 107a causes the first diode to be reverse biased in the vicinity of the first contact 107a. The substrate 101 may be coupled to a low voltage. Because the first well 102 is coupled to a high voltage and the substrate 101 to a low voltage, the second diode may be reverse biased.

The reverse bias voltage over the first diode in the vicinity of the first contact 107a may cause a depletion layer 106 in the body of the resistor (in this case a p+ diffusion well). This depletion layer is dependent on the reverse bias voltage across the first diode and the resistor becomes voltage dependent. This may lead to a non-linear behaviour of the resistor.

In the example of figure 1, the resistor is implemented as a voltage divider with four equidistant contacts 107a, 107c, 107d and 107b. As the depletion layer 106 thickness decreases from the area in the vicinity of the first contact 107a, past the third and fourth contacts 107c, 107d and to the second contact 107b, the resistor values will decrease accordingly. In this case, the equidistant contacts 107a, 107c, 107d and 107b will not lead to equal voltage differences.

In one example, a resistor divider may be implemented using the diffused resistor of figure 1 but providing a plurality of these diffused resistors coupled in series. Each of the individual diffused resistors will behave non-linearly.

In the following, a connection scheme may be provided for a diffused resistor in order to address an issue of non-linearity in the resistor.

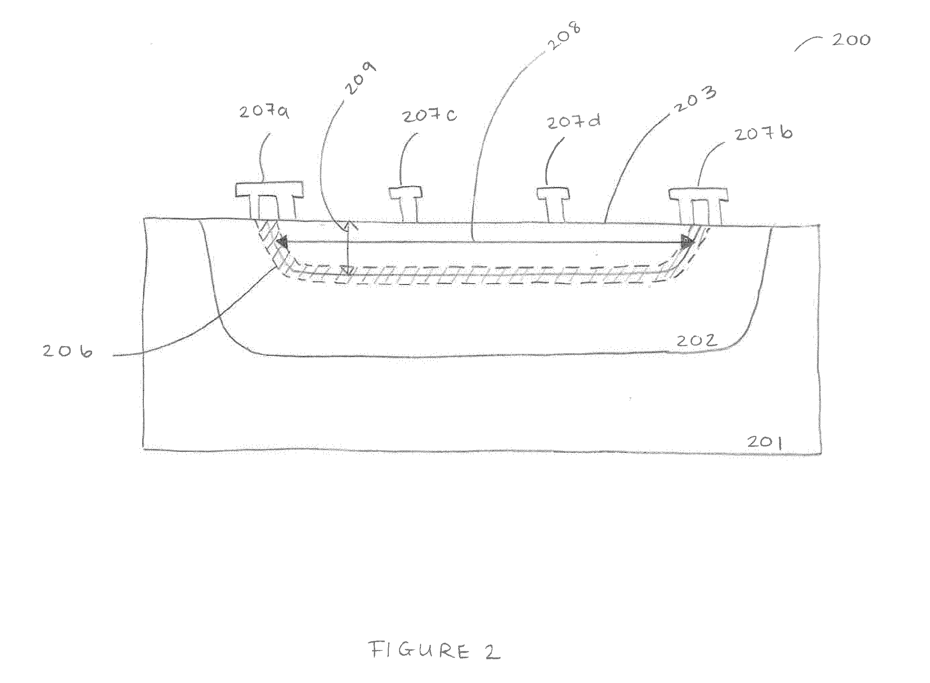

Figure 2 is a schematic diagram showing a semiconductor device 200 comprising a diffused resistor in accordance with a first embodiment.

The semiconductor device 200 comprises a substrate 201, a first well 202 and a second well 203 within the first well 202. The second well 203 may be a diffused region within the first well 202 having a conductivity type opposite to that of the first well 202. The second well 203 may form a body of the resistor. Four contacts 207a, 207c, 207d and 207b are provided on a top surface of the second well 203. The contacts 207a-d may be configured to couple the resistor to further circuitry.

In one example, the substrate 201 may be a p-type epitaxial layer, the first well 202 may be an n-type well and the second well 203 may be a p-type well. The second well 203 may be formed by the introduction or diffusion of p-type impurities into the n-type first well 202. The p-type second well 203 may form a body of the resistor. The second well 203 may form a p+ diffusion area.

It will however be appreciated that these conductivity types are by way of example only and, in other examples, embodiments may be provided with a complementary conductivity type - namely, the substrate and second well may be n-type and the first well may be a p-type well and the resistor body may be provided as an n+ resistor.

In the example of figure 2, the first contact 207a and the second contact 207b may be provided at a boundary between the first well 202 and second well 203. The third and fourth contacts 207c and 207d may be provided on a surface of the second well 203 and be arranged between the first and second contacts 207a and 207b. In this example, the four contacts 207a,c,d and b are spaced equidistantly along the surface of the second well 203 in order to provide a resistor divider. It will however be appreciated that in some embodiments, only the first and second contacts 207a and 207b may be provided for a single resistor value.

The first contact 207a may be coupled to a low voltage side (V_{L}) of the resistor and the second contact 207b may be coupled to a high voltage side (V_{H}) of the resistor. In examples, when the resistor 200 of figure 2 is coupled to further circuitry (either further semiconductor device on the same or different substrate or external devices) the first contact 207a may be coupled to a provide a low voltage terminal for the resistor and the second contact 207b may be coupled to provide a high voltage terminal for the resistor. In the implementation of a resistor divider, the third and fourth contacts 207c and 207d may be coupled to provide a division of the voltage (V_{H}-V_{L}) across the resistor.

The second well 203 may have an elongated shape comprising two major sides forming a length 208 along the surface of the device, two minor sides forming a width (not shown) along the surface of the device and a depth 209 defined as the distance between the top surface of the second well and the bottom surface of the second well. The first contact may be provided on a boundary between the first and second well defined by the first minor side and the second contact may be provided on a boundary between the first and second well defined by the second minor side.

The first contact 207a is coupled to both the first well 202 and to the second well 203. The second contact is coupled to both the first well 202 and to the second well 203. The first and second contacts may be separated by the length 208 of the second well 203. In this example, the first and second contacts 207a and 207b straddle the respective boundaries between the first well 202 and the second well 203.

As described, the second contact 207b is coupled to both the second well or resistor body 203 and the first well 201. In this case, the voltage or potential of the second well 203 and the voltage or potential of the first well 202 is equal in the vicinity of the second contact 207b. In addition, the first contact 207a is coupled to both the second well 203 and the first well 202. In this case the voltage or potential of the second well 203 and the voltage or potential of the first well 202 is equal in the vicinity of the first contact 207a. In other words, the first well 202 is coupled to both the low voltage terminal (V_{L}) 207a and the high voltage terminal (V_{H}) 207b of the resistor. Optionally, in some examples, the first or low voltage contact 207a may further be coupled to the substrate 201.

With this connection scheme, the voltage difference between the second well 203 and first well 202 across a diode representing the relationship between the second and first wells 203 and 202 may be substantially constant over the diode moving from the low voltage terminal to the high voltage terminal. The resulting depletion layer shown at 206 may now be less dependent on voltage and the resistor may be considered to be more linear as compared to the resistor of figure 1.

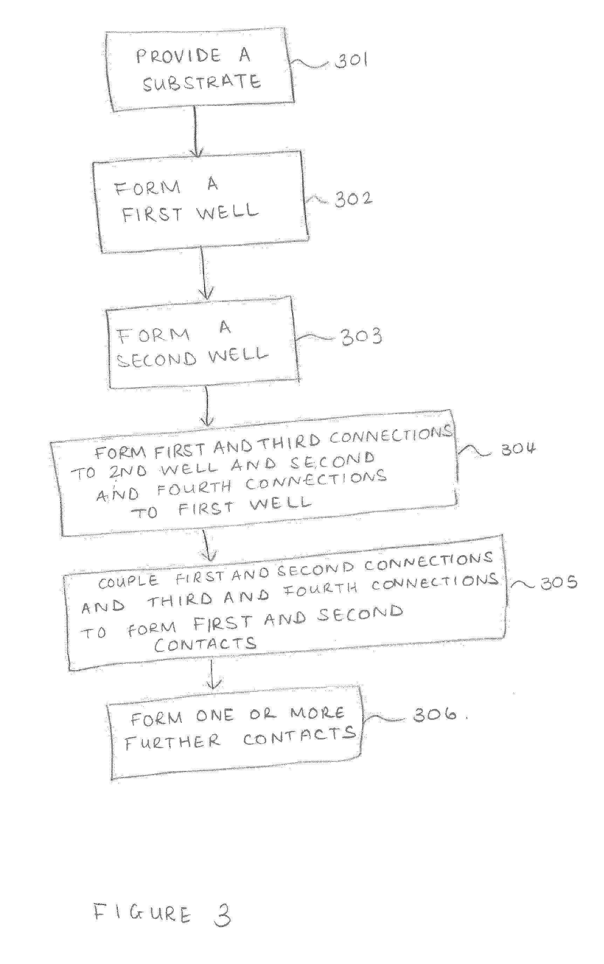

Figure 3 is a flow diagram depicting example method steps associated with the manufacturing of a resistor or resistor divider in accordance with the first embodiment. It will be appreciated that the processing steps for manufacturing a diffused resistor are not described in detail. It will be appreciated that the connection scheme of embodiments may be implemented with a variety of processes for manufacturing diffused resistors and is not restricted to the example of figure 3.

At step 301, a substrate is provided. In this example, the substrate may be a p-type epitaxial layer. At step 302, a first well may be formed in the substrate. The first well may be an n-type well. The first well may be defined by a top surface, a bottom surface and lateral wall. The lateral walls and bottom surface may be entirely surrounded by the substrate. At step 303, a second well may be formed in the first well. The second well may be formed by the diffusion of impurities in the first well. In this example, the second well may be a p-type well and may form a p+ diffusion layer within the first well. The second well may have a bottom surface, a top surface and lateral walls. The bottom surface and lateral walls of the second well may be entirely surrounded by the first well.

At steps 304 and 305, the first and second contacts 207a and 207b may be formed on the top surface of the device at a boundary on the top surface between the first well 202 and the second well 203. The second well 203 may be formed to have an elongated shape comprising two major sides forming a length 208 along the surface of the device, two minor sides forming a width (not shown) along the surface of the device and a depth 209 defined as the distance between the top surface of the second well and the bottom surface of the second well. The first contact 207a may be formed on a boundary between the first 202 and second well 203 defined by the first minor side and the second contact 207b may be provided on a boundary between the first 202 and second 203 well defined by the second minor side.

The first contact 207a may be formed by forming a first connection to the second well 203 and a second connection to the first well 202 and then coupling the first and second connections together to form the first contact. Similarly, the second contact 207b may be formed by forming a third connection to the second well 203 and a fourth connection to the first well 202 and then coupling the third and fourth connections together.

At step 304, the first, second, third and fourth connections are formed on the respective surfaces of the first well 202 and the second well 203. At step 305, the first and second connections are coupled together to form the first contact 207a and the third and fourth connections are coupled together to form the second contact 207b.

The first and second contacts may be separated by the length of the second well. In one example the first and second contact may straddle their respective boundaries between the first well 202 and the second well 203.

At step 305, one or more further contacts 207c, 207d may be formed between in the first and second contacts on the surface of the second well 203. It will be appreciated that the formation of these one or more further contacts may be carried out by forming further connections on the surface of the second well at step 304.

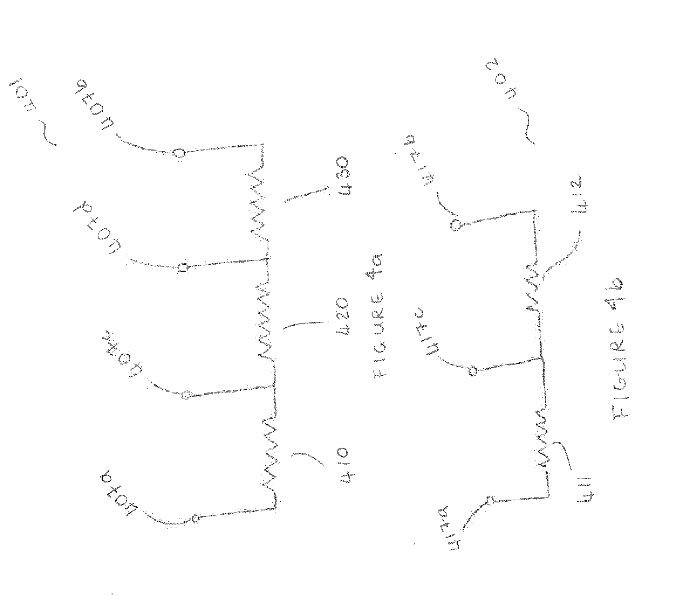

Examples of circuit diagrams of resistor dividers shown in circuit diagram schematics in figures 4a and 4b.

Figure 4a shows an example of a resistor divider 401 comprising a first resistor 410, a second resistor 420 and a third resistor 430. The resistor divider 401 comprises a first, low voltage terminal (V_{L}) 407a and a second, high voltage terminal (V_{H}) 407b. The resistor divider may further comprise a third terminal 407c and a fourth terminal 407d which may be coupled to provide a division of the voltage (V_{H}-V_{L}) across the resistor divider 401.

In one example, the resistor divider may correspond to the example of figure 2, where the first, low voltage terminal 407a may be provided by the first contact 207a, the second, high voltage terminal 407b may be provided by the second contact 207b, and the third and fourth terminals 407c and 407d may be respectively provided by the third and fourth contacts 207c and 207d.

In this example, the first resistor 410 may correspond to the resistance provided by the portion of the resistor body 203 between the first contact 207a and third contact 207c, the second resistor 420 may correspond to the resistance provided by the portion of the resistor body 203 between the third contact 207c and the fourth contact 207d, and the third resistor 430 may correspond to the resistance provided by the portion of the resistor body 203 between the fourth contact 207d and the second contact 207b

While figure 4a shows a four terminal resistor divider 401, it will be appreciated that resistor dividers may be implemented in accordance with embodiments having more or fewer terminals. To illustrate this, figure 4b shows an example of a three terminal device.

Figure 4b shows an example of a resistor divider comprising a first resistor 411 and a second resistor 412. The resistor divider comprises a first, low voltage terminal (V_{L}) 417a and a second, high voltage terminal (V_{H}) 417b. The resistor divider further comprises a third terminal 417c which may be coupled to provide a division of the voltage (V_{H}-V_{L}) across the resistor divider.

The resistor divider may correspond to a diffused resistor implementation similar to that of figure 2, except where only one further contact is formed equidistantly between the first contact 207a and the second contact 207b. A resistor divider may comprise a first and second terminal provided by a respective low and high voltage connection, as well as optional additional terminals to provide voltage divider functionality. It will be appreciated that in some cases, a two terminal device may just be considered to be a resistor with additional terminals providing a resistor divider.

Figures 3 has depicted the method steps that are associated with some examples. It will be appreciated that in some examples further or additional layers may be formed. For example, the contacts may include one or more layers and further layers may be added on the top surface of the resistor, for example to provide a protective layer.

It will be appreciated that the wells and substrate may be formed using any suitable method. For example an n-type epitaxial layer may be grown on the p-type substrate to form the first well. The second well may be formed by diffusing p-type impurities into the n-type well to a depth, length and width which, together with the resistivity of the diffused material may determine the value of the resistor. The resultant resistance of the resistor or resistor divider may be determined by:

R= Ω(L/A) = Ω(L/W.t) (1)

With the parameters defined as follows:
Ω is the average resistivity of the diffused layer (second well);
L is the length of the diffused layer;
W is the width of the diffused layer;
t is the thickness or depth of the diffused layer; and
A is the cross-sectional area of the diffused layer.

It will be appreciated that these parameters will be chosen to provide the required resistance.

A resistor or resistor divider in accordance with embodiments may be used in a variety of applications. Such resistors or resistor dividers may be useful in applications where a polysilicon mask is not implemented during the manufacture of a semiconductor device, for example in cases where a high-k metal dielectric is used for a gate contact of a MOSFET. Such resistors or resistor dividers may be useful in applications where linear resistors are required.

Examples of applications in which a resistor or resistor divider of embodiments may be used includes, but is not restricted to, analogue to digital converters (ADC), digital to analogue converters (DAC), voltage to current converters, current to voltage converters, circuits providing a frequency reference, circuits providing a voltage reference and/or circuits providing a current reference.

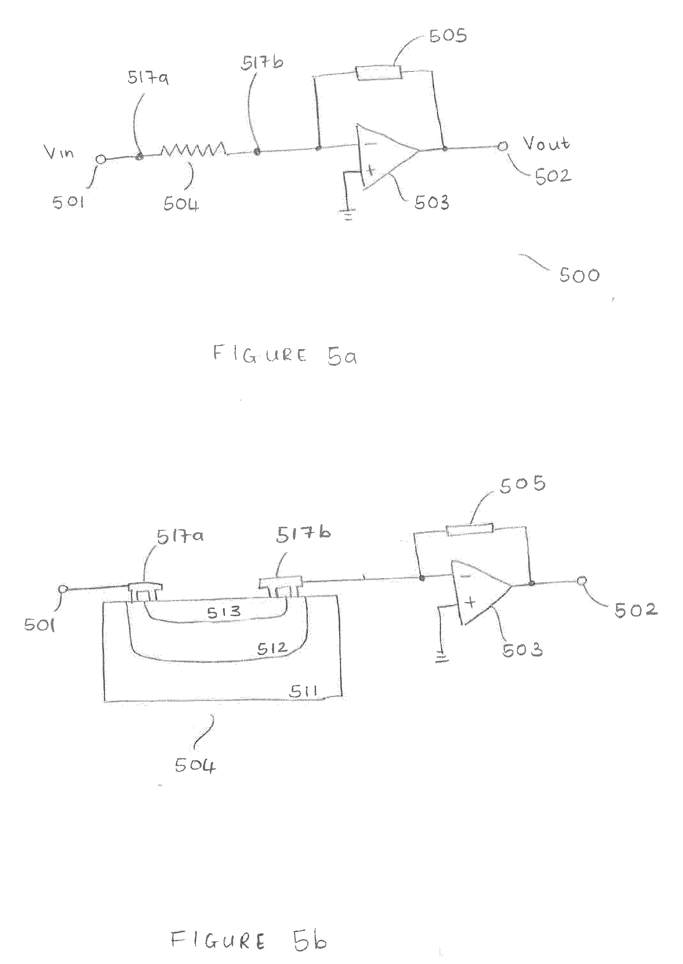

Figures 5a and 5b depict one such example application of a resistor in the form of a voltage to current converter.

Figure 5a shows a circuit diagram of a voltage to current converter in which embodiments may be implemented. The voltage to current converter 500 comprises an input node 501 for receiving a voltage input signal (Vᵢₙ), an output node 502 for outputting a voltage output signal (Vₒᵤₜ), an amplifier 503, an impedance 505 and a resistor 504.

The Vᵢₙ 501 is coupled to a first terminal 517a of the resistor 504. A second terminal 517b of the resistor 504 is coupled to an inverting input of the amplifier 503. A non-inverting input of the amplifier 503 is coupled to a reference voltage, in this case ground. The Vₒᵤₜ 502 is provided at the output of the amplifier 503 with the impedance 505 coupled between the inverting input of the amplifier 503 and Vₒᵤₜ 502. In this example the resistor 504 may have a resistance of R.

In operation, the inverting input of the amplifier 503 act as a virtual ground and Vᵢₙ is converted into a current, ideally corresponding to Vᵢₙ/R. The current (I=Vᵢₙ/R) runs through the impedance 505 and is provided at the output 502.

Figure 5b shows the voltage to current converter of figure 5a implementing a resistor in accordance with an embodiment of the disclosure. It will be appreciated that here, like reference numeral refer to like features.

The resistor 504 of figure 5b comprises a substrate 511, a first well 512, a second well 513, a first contact 517a and a second contact 517b. The first and second contacts provide the first and second terminals for the resistor 503. Vᵢₙ 501 is coupled to the first contact or terminal 517a. The first contact 517a is coupled to both the first well 512 and the second well 513 and the first and second well are at the same voltage at this point. The second terminal 517b is coupled to the non-inverting input of the amplifier 503. The second contact 517b is coupled to both the first well 512 and second well 513. In this case, the voltage difference between the first and second wells 512 and 513 from the first contact 517a to the second contact 517b may be constant. The resistor 504 may satisfy the linearity requirements of the voltage to current converter.

It will be appreciated that figure 5b provides a resistor in accordance with the first example, however, it will be appreciated that a resistor divider in accordance with the second example may alternatively be implemented as the resistor 504 of figures 5a and 5b.

The described embodiments are to be considered in all respects only as illustrative and not restrictive. The scope of the invention is, therefore, indicated by the appended claims rather than by this detailed description. All changes that come within the meaning and range of equivalency of the claims are to be embraced within their scope.

For example, in the foregoing, an example has been shown as having four contacts. It will however be appreciated that a resistor in accordance with embodiments may be implemented with at least a first contact coupled to a low voltage side or terminal of the resistor and a second contact coupled to a high voltage side or terminal of the resistor.

Furthermore, while the contacts have been depicted as being spaced equidistantly in the foregoing, this may not always be the case. For example, a resistor divider may divide along a different ratio and the contacts may not all be spaced equidistantly. In some cases, the resistor components may be of differing sizes for a differing voltage division ratio.

Reference throughout this specification to features, advantages, or similar language does not imply that all of the features and advantages that may be realized with the present invention should be or are in any single embodiment. Rather, language referring to the features and advantages is understood to mean that a specific feature, advantage, or characteristic described in connection with an embodiment is included in at least one embodiment. Thus, discussions of the features and advantages, and similar language, throughout this specification may, but do not necessarily, refer to the same embodiment.

One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

## Claims

1. A diffused resistor comprising:
a substrate having a first conductivity type;
a first well within the substrate having a second conductivity type;
a second well within the first well having the first conductivity type;
a first and second contact for coupling the resistor to further circuitry;
wherein the first and second contacts are each coupled to both the first well and the second well.

2. The diffused resistor of claim 1 wherein the second well is configured to form a resistor body.

3. The diffused resistor of claim 2 wherein the first contact is coupled to both the first well and the second well on a first side of the resistor and the second contact is coupled to both the first well and the second well on a second side.

4. The diffused resistor of any preceding claim wherein the second conductivity type is opposite the first conductivity type.

5. The diffused resistor of any preceding claim wherein the first conductivity type is one of an n-type or a p-type and the second conductivity type is the other one of the n-type or the p-type.

6. The diffused resistor of any preceding claim wherein the first contact is configured to provide a low voltage terminal of the diffused resistor.

7. The diffused resistor of any preceding claim wherein the second contact is configured to provide a high voltage terminal of the diffused resistor.

8. The diffused resistor of any preceding claim further comprising:
one or more further contacts provided between the first and second contacts.

9. The diffused resistor of any preceding claim wherein the contacts are provided on a top surface of the second well.

10. The diffused resistor of any preceding claim wherein the diffused resistor is a resistor divider.

11. A semiconductor device comprising a diffused resistor according to any of claims 1 to 10.

12. A method comprising:
providing a substrate having a first conductivity type;
forming a first well within the substrate having a second conductivity type;
forming a second well within the first well having the first conductivity type;
forming a first and second contact for coupling the resistor body to further circuitry;
wherein forming the first and second contact further comprises:
forming the first contact with connections to the first well and the second well; and
forming the second contact with connections to the first well and the second well.

13. The method of claim 12 wherein forming the second well forms a resistor body.

14. The method of claim 13 wherein the first contact is formed on a first side of the resistor body and the second contact is formed on a second side of the resistor body.

15. A voltage to current converter comprising:
a voltage input;
a voltage output;
an amplifier comprising:
an amplifier output coupled to the voltage output;
an impedance coupled between the voltage output and an inverting input of the amplifier; and
a non-inverting input coupled to ground;
wherein the voltage to current converter further comprises:
the resistor of claim 1 wherein the first contact is coupled to the voltage input and the second contact is coupled to the inverting input of the amplifier.
